# EUROPEAN PATENT APPLICATION

(11) **EP 1 511 070 A2**
(43) Date of publication of application: **02.03.2005**
(21) Application number: 04104015.5
(22) Date of filing: 20.08.2004
(51) Int. Cl.: H01L 21/02

(54) **Integrated circuit capacitor in multi-level metallization**

(30) Priority: 26.08.2003 US 650100
(71) Applicant: TEXAS INSTRUMENTS INCORPORATED, Dallas 75265 (US)
(72) Inventor: Hong, Qi-Zhong, Richardson, TX Texas 75082 (US)
(74) Representative: Holt, Michael

(57) **Abstract**

An integrated circuit capacitor is formed by first forming a first dielectric layer (25) over a semiconductor (10). A copper structure (35) is formed in the first dielectric layer (25) and a second dielectric layer (80) is formed over the copper structure (35). A metal containing layer (90) is formed over the second dielectric layer (80) and the copper structure (35) and a planar surface is formed by removing portions of the metal containing layer (90) and the second dielectric layer (80). The second dielectric layer (80) can comprise a high-k dielectric material. The metal containing layer can comprise two metal layers.

## Description

### FIELD OF THE INVENTION

The invention is generally related to the field of integrated circuit capacitors and more specifically to a new structure for integrated circuit capacitors and a method of forming the same in integrated circuits comprising multi-level metallization.

### BACKGROUND OF THE INVENTION

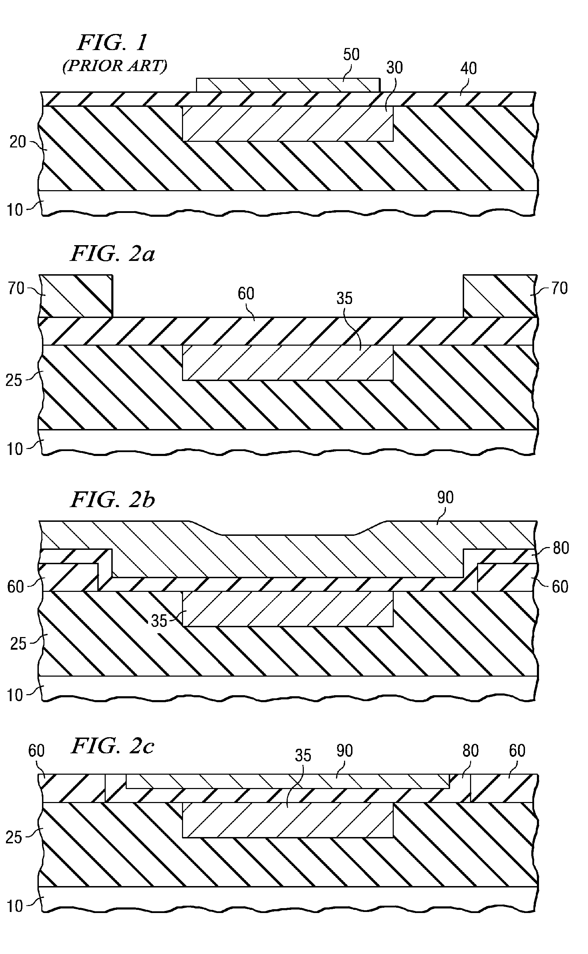

There is often a need for high precision capacitors on analog and mixed signal integrated circuits. Analog-to-digital converters and filters are just two of the many types of integrated circuits that would require these precision capacitors. Presently most of these capacitors comprise a dielectric layer sandwiched between two metal layers. Shown in Figure 1 is a typical capacitor formed according to the prior art. A copper layer 30 is formed in a dielectric layer 20 using known methods. The dielectric layer 20 is formed over the semiconductor 10 that contains the various electronic devices that comprise the integrated circuit. There can be any number of addition layers positioned between the semiconductor 10 and the dielectric layer 20. These additional layers can comprise dielectric layers and metal layers, as well as any other type of additional layer required for the integrated circuit. The electronic devices in the semiconductor 10 and any additional layers positioned between the semiconductor 10 and the dielectric layer 20 are omitted from Figure 1 for clarity.

A dielectric layer 40 is formed over the copper layer 30 as shown in Figure 1 and will function as the capacitor dielectric. The copper layer 30 will function as one of the plates of the capacitor. A metal layer 50 is formed and patterned over the dielectric layer 40 and the copper layer 30 and functions as the other capacitor plate. The metal layer 50 usually comprises a metal such a tantalum or tantalum nitride. The metal layer 50 is formed by first forming a blanket metal layer. A patterned photoresist layer is then formed over a portion of the blanket metal layer and the uncovered portions of metal etched to form the patterned layer 50 shown in Figure 1.

The above described method of forming integrated circuit capacitors has a number of shortcomings. Firstly, the resulting figure of merit (FOM) for the entire metal interconnect structure (that includes the capacitor structure) is degraded. In addition the process does not lend itself to the use of high K dielectric materials such as hafnium oxide to form the capacitor dielectric layer.

There is therefore a need for integrated circuit capacitor structures that do not degrade the figure of merit and are compatible with the use of high K dielectric materials. The instant invention addresses these needs.

### SUMMARY OF THE INVENTION

A method for forming an integrated circuit capacitor with a high FOM is presented. The method comprises forming a dielectric layer over a semiconductor. A copper structure is formed in the dielectric layer and will function as a plate of the capacitor. A first dielectric layer is formed over the copper structure and a metal containing layer is formed over the dielectric layer and the copper structure. A planar surface is formed by removing portions of the first dielectric layer and the metal containing layer. The region of the first dielectric layer remaining over the copper structure will function as the capacitor dielectric. The region of the metal containing layer remaining over the first dielectric layer and the copper structure will function as a plate of the capacitor. In an embodiment of the instant invention chemical mechanical polishing is used to form the planar surface. In a further embodiment of the instant invention a second metal containing layer if formed over the metal containing layer prior to forming the planar surface. In this embodiment the capacitor plate is formed from a combination of the metal containing layer and the first metal containing layer.

### BRIEF DESCRIPTION OF THE DRAWINGS

In the drawings:
FIGURE 1 shows the cross-section of an integrated circuit capacitor according to the prior art.
FIGURE 2(a) to FIGURE 2(c) are cross-sectional diagrams showing an embodiment of the instant invention.
FIGURE 3(a) to FIGURE 3(c) are cross-sectional diagrams showing a further embodiment of the instant invention.

Common reference numerals are used throughout the figures to represent like or similar features. The figures are not drawn to scale and are merely provided for illustrative purposes.

### DETAILED DESCRIPTION OF THE INVENTION

While the following description of the instant invention revolves around Figures 2(a) to Figure 3(c), the instant invention can be utilized in many semiconductor device structures. The methodology of the instant invention provides a solution to forming precision integrated circuit capacitors.

An embodiment of the instant invention will now be described by referring to Figures 2(a) to Figure 2(c). Referring to Figure 2(a), a semiconductor 10 is provided. The semiconductor will contain any number of electronic devices such as transistors, resistors, diodes, etc. These electronic devices can be formed in the semiconductor 10 using any number of known methods. The electronic devices are omitted from all the diagrams for clarity. As shown in Figure 2(a), a dielectric layer 25 is formed over the semiconductor 10. Although omitted from the diagrams for clarity, any number of addition layers can be formed between the semiconductor 10 and the dielectric layer 25. In an embodiment, the dielectric layer 25 can comprise silicon dioxide, any spin-on-glass (SOG) (such as siloxane, silsesquioxanes, cage silsesquioxanes), xerogels, oganosilicate glass (OSG), fluorinated silica glass (FSG), or any other suitable material. A copper structure 35 is formed in the dielectric layer 25 using known semiconductor processing methods. The copper structure will function as a first plate of the integrated circuit capacitor. Following the formation of the copper structure 35, a barrier layer 60 is formed over the dielectric layer 25 and the copper structure 35. In an embodiment, the barrier layer 60 can comprise silicon nitride, silicon carbide containing oxygen (SiCO), silicon carbide containing nitrogen (SiCN), or any other suitable material. The barrier layer can be formed in thicknesses ranging from about 100A to 2000A. Following the formation of the barrier layer 60, patterned photoresist 70 is formed as shown in Figure 2(a). The patterned photoresist is used as an etch mask during the removal of the exposed (or uncovered) regions of the barrier layer 60 shown in Figure 2(a).

As shown in Figure 2(b), following the etching of the exposed regions of the barrier layer 60 and the removal of the patterned photoresist 70, a dielectric layer 80 is formed over the exposed region of the copper structure 35 and the remaining regions of the barrier layer 60. In an embodiment, the dielectric layer 80 can comprise silicon nitride, silicon oxide, hafnium oxide, silicon oxynitride, aluminum oxide, or any other suitable dielectric material. Following the formation of the dielectric layer 80, a metal containing layer 90 is formed over the dielectric layer. In an embodiment, the metal containing layer can comprise tantalum, tantalum nitride, copper, aluminum, titanium, titanium nitride, or any other suitable metal.

Following the formation of the structure shown in Figure 2(b), the structure is planarized to the level of the upper surface of the barrier layer 60 resulting in the structure shown in Figure 2(c). Planarizing the structure to the level of the upper surface of the barrier layer 60 results in the removal of a portion of the dielectric layer 80, a portion of the metal containing layer 90, and the formation of a planar surface. The planarizing of the structure can be performed using any number of methods. In an embodiment of the instant invention, the structure can be planarized using chemical mechanical polishing (CMP). In the CMP process, a polishing pad and slurry are used to remove the required portions of the metal containing layer 90 and the dielectric layer 80 to form the capacitor structure.

As stated above, the copper structure 35 functions as a plate of the capacitor. The remaining portion of the dielectric layer 80 shown in Figure 2(c) functions as the capacitor dielectric, and the remaining portion of the metal containing layer 90 functions as the other plate of the capacitor. Following the planarization of the structure, the integrated circuit can be completed using known processing methods. The resulting capacitor structure shown in Figure 2(c) does not reduce the FOM and allows the use of alternative high k dielectric materials to form the capacitor dielectric.

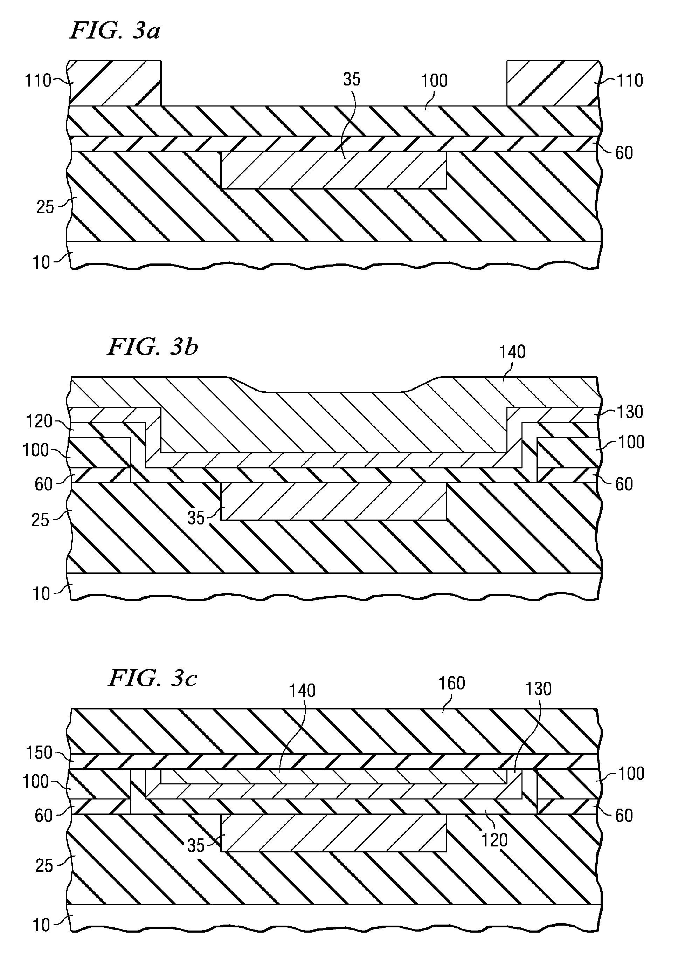

Illustrated in Figures 3(a) to Figure 3(c) is a further embodiment of the instant invention. Referring to Figure 3(a), a semiconductor 10 is provided. The semiconductor will contain any number of electronic devices such as transistors, resistors, diodes, etc. These electronic devices can be formed in the semiconductor 10 using any number of known methods. The electronic devices are omitted from all the diagrams for clarity. As shown in Figure 3(a), a dielectric layer 25 is formed over the semiconductor 10. Although omitted from the diagrams for clarity, any number of addition layers can be formed between the semiconductor 10 and the dielectric layer 25. In an embodiment, the dielectric layer 25 can comprise silicon dioxide, any spin-on-glass (SOG) (such as siloxane, silsesquioxanes, and cage silsesquioxanes), xerogels, oganosilicate glass (OSG), fluorinated silica glass (FSG), or any other suitable material. A copper structure 35 is formed in the dielectric layer 25 using known semiconductor processing methods. The copper structure will function as a first plate of the integrated circuit capacitor. Following the formation of the copper structure 35, a barrier layer 60 is formed over the dielectric layer 25 and the copper structure 35. In an embodiment, the barrier layer can comprise silicon nitride, silicon carbide containing oxygen (SiCO), silicon carbide containing nitrogen (SiCN), or any other suitable material. The barrier layer can be formed in thicknesses ranging from about 10A to 2000A. Following the formation of the barrier layer 60, a dielectric layer 100 is formed over the barrier layer 60. In an embodiment, the dielectric layer 100 can comprise silicon dioxide, any spin-on-glass (SOG) (such as siloxane, silsesquioxanes, cage silsesquioxanes), xerogels, oganosilicate glass (OSG), fluorinated silica glass (FSG), or any other suitable material. Following the formation of the dielectric layer 100, a patterned photoresist 110 is formed as shown in Figure 3(a). The patterned photoresist 110 is used as an etch mask during the removal of the exposed (or unmasked) regions of the dielectric layer 100 and the barrier layer 60 shown in Figure 3(a).

As shown in Figure 3(b), following the etching of the unmasked regions of the barrier layer 60 and the dielectric layer 100, the patterned photoresist 110 is removed. A dielectric layer 120 is formed over the exposed region of the copper structure 35 and the remaining regions of the barrier layer dielectric layer 100. In an embodiment, the second dielectric layer 120 can comprise silicon nitride, silicon oxide, hafnium oxide, silicon oxynitride, aluminum oxide, or any other suitable dielectric material. Following the formation of the dielectric layer 120, a metal containing layer 130 is formed over the dielectric layer 120. In an embodiment, the metal containing layer 120 can comprise tantalum, tantalum nitride, copper, aluminum, titanium, titanium nitride, or any other suitable metal. Following the formation of the metal containing layer 130, a second metal containing layer 140 is formed over the metal containing layer 130 as shown in Figure 3(b). In an embodiment, the second metal containing layer 130 can comprise tantalum, tantalum nitride, copper, aluminum, titanium, titanium nitride, or any other suitable metal.

Following the formation of the structure shown in Figure 3(b), the structure is planarized to the level of the upper surface of the dielectric layer 100 as shown in Figure 3(c). Planarizing the structure to the level of the upper surface of the dielectric layer 100 results in the removal of a portion of the second metal containing layer 140, a portion of the metal containing layer 130, a portion of the dielectric layer 120, and the formation of a planar surface. The planarizing of the structure can be performed using any number of methods. In an embodiment of the instant invention, the structure can be planarized using chemical mechanical polishing (CMP). In the CMP process, a polishing pad and slurry are used to remove the required portions of the second metal containing layer 140, the metal containing layer 130, and the dielectric layer 120 to form the capacitor structure. As stated above the copper structure 35 functions as a plate of the capacitor. The remaining portion of the dielectric layer 120 shown in Figure 3(c) will function as the capacitor dielectric, and the remaining portion of the metal containing layer 130 and the second metal containing layer 140 will function as the other plate of the capacitor. Following the planarization process, a second barrier layer 150 can be formed over the capacitor structure. In an embodiment, the second barrier layer 150 can comprise silicon nitride, silicon carbide containing oxygen (SiCO), silicon carbide containing nitrogen (SiCN), or any other suitable material. Following the formation of the second barrier layer 150, a dielectric layer 160 is formed over the second barrier layer. In an embodiment, the dielectric layer 160 can comprise silicon dioxide, any spin-on-glass (SOG) (such as siloxane, silsesquioxanes, cage silsesquioxanes), xerogels, oganosilicate glass (OSG), fluorinated silica glass (FSG), or any other suitable material. Following the formation of the dielectric layer 160, the integrated circuit can be completed using known methods. The resulting capacitor structure shown in Figure 3(c) does not reduce the FOM and allows the use of alternative high k dielectric materials to form the capacitor dielectric.

While this invention has been described with reference to illustrative embodiments, this description is not intended to be construed in a limiting sense. Various modifications and combinations of the illustrative embodiments, as well as other embodiments of the invention will be apparent to persons skilled in the art upon reference to the description. It is therefore intended that the appended claims encompass any such modifications or embodiments.

## Claims

1. A method for forming a capacitor, comprising:
providing a semiconductor;
forming a first dielectric layer over said semiconductor;
forming a copper structure in said dielectric layer;
forming a second dielectric layer over said copper structure;
forming a metal containing layer over said second dielectric layer; and
forming a planar surface by removing portions of said second dielectric layer and said metal containing layer.

2. The method of claim 1, wherein said second dielectric layer consists of a material selected from the group consisting of silicon nitride, silicon oxide, hafnium oxide, silicon oxynitride, and aluminum oxide.

3. The method of either claim 1 or claim 2, wherein said metal containing layer consists of a material selected from the group consisting of tantalum, tantalum nitride, copper, aluminum, titanium, and titanium nitride.

4. The method of any of claims 1 - 3, wherein said planar surface forming step comprises chemical mechanical polishing.

5. The method of any of claims 1 - 4, wherein said step of forming a metal containing layer comprises:
forming a first metal containing layer over said second dielectric layer; and
forming a second metal containing layer over said first metal containing layer; and wherein said step of forming a planar surface comprises forming a planar surface by removing portions of said second dielectric layer, said first metal containing layer, and said second metal containing layer.

6. The method of claim 5 (not dependent from claim 3), wherein said first metal containing layer consists of a material selected from the group consisting of tantalum, tantalum nitride, copper, aluminum, titanium, and titanium nitride.

7. The method of claim 6, wherein said second metal containing layer consists of a material selected from the group consisting of tantalum, tantalum nitride, copper, aluminum, titanium, and titanium nitride.
